# EUROPÄISCHE PATENTSCHRIFT

(11) **EP 1 706 519 B1**
(45) Veröffentlichungstag und Bekanntmachung des Hinweises auf die Patenterteilung: **21.08.2013**
(21) Anmeldenummer: 05706687.0
(22) Anmeldetag: 18.01.2005
(51) Int. Cl.: C23C 14/34, C23C 14/08, H01L 31/18, H01L 31/0224, C23C 14/00

(54) **VERFAHREN ZUR HERSTELLUNG EINER TRANSPARENTEN UND LEITFÄHIGEN OXIDSCHICHT**
METHOD FOR MAKING A TRANSPARENT AND CONDUCTIVE OXIDE LAYER
PRODEDE DE PREPARATION D'UNE COUCHE D'OXYDE TRANSPARENTE ET CONDUCTRICE

(30) Priorität: 23.01.2004 DE 102004003760
(43) Veröffentlichungstag der Anmeldung: 04.10.2006
(73) Patentinhaber: Forschungszentrum Jülich GmbH, 52425 Jülich (DE)
(72) Erfinder: RECH, Bernd, 12587 Berlin (DE); HÜPKES, Jürgen, 47877 Willich (DE); KLUTH, Oliver, 8880 Walenstadt St. Gallen (CH); MUELLER, Joachim, 70736 Fellbach (DE)
(86) Internationale Anmeldenummer: PCT/DE2005/000059
(87) Internationale Veröffentlichungsnummer: WO 2005/071131

(56) Entgegenhaltungen:
- KON M ET AL: "IMPEDANCE CONTROL OF REACTIVE SPUTTERING PROCESS IN MID-FREQUENCY MODE WITH DUAL CATHODES TO DEPOSIT AL-DOPED ZNO FILMS" JAPANESE JOURNAL OF APPLIED PHYSICS, PUBLICATION OFFICE JAPANESE JOURNAL OF APPLIED PHYSICS. TOKYO, JP, Bd. 42, Nr. PART 1, 1, Januar 2003 (2003-01), Seiten 263-269, XP001090514 ISSN: 0021-4922
- S. JAEGER ET AL: "Comparison of transparent conductive oxide thin films prepared by a.c. and d.c. reactive magnetron sputtering" SURFACE AND COATINGS TECHNOLOGY, Bd. 98, Nr. 1-3, 1. Januar 1998 (1998-01-01), Seiten 1304-1314, XP002338603 ch
- PATENT ABSTRACTS OF JAPAN Bd. 2003, Nr. 07, 3. Juli 2003 (2003-07-03) & JP 2003 068643 A (JAPAN ADVANCED INST OF SCIENCE & TECHNOLOGY HOKURIKU), 7. März 2003 (2003-03-07)
- PATENT ABSTRACTS OF JAPAN Bd. 015, Nr. 453 (E-1134), 18. November 1991 (1991-11-18) & JP 03 191578 A (MITSUBISHI ELECTRIC CORP), 21. August 1991 (1991-08-21)
- BOSE S ET AL: "TEXTURED ALUMINIUM-DOPED ZNO THIN FILMS PREPARED BY MAGNETRON SPUTTERING" JOURNAL OF PHYSICS D. APPLIED PHYSICS, IOP PUBLISHING, BRISTOL, GB, Bd. 29, Nr. 7, 14. Juli 1996 (1996-07-14), Seiten 1873-1877, XP000621105 ISSN: 0022-3727
- CHANG J F ET AL: "The effect of deposition temperature on the properties of Al-doped zinc oxide thin films" THIN SOLID FILMS, ELSEVIER-SEQUOIA S.A. LAUSANNE, CH, Bd. 386, Nr. 1, 1. Mai 2001 (2001-05-01), Seiten 79-86, XP004230504 ISSN: 0040-6090
- AGASHE C ET AL: "Optimization of the electrical properties of magnetron sputtered aluminum-doped zinc oxide films for opto-electronic applications", THIN SOLID FILMS, ELSEVIER-SEQUOIA S.A. LAUSANNE, CH, vol. 442, no. 1-2, 1 October 2003 (2003-10-01), pages 167-172, XP004458317, ISSN: 0040-6090, DOI: 10.1016/S0040-6090(03)00966-0

## Beschreibung

Die Erfindung betrifft ein Herstellungsverfahren für eine transparente, leitfähige Zinkoxidschicht, die insbesondere für den Einsatz in einer Dünnschichtsolarzelle geeignet ist.

### Stand der Technik

Solarmodule auf Basis der kristallinen Si-Wafertechnologie haben bereits seit Jahren ihre Leistungsfähigkeit und Zuverlässigkeit bewiesen. Module der Dünnschichttechnologie, die auf Halbleitern basieren und großflächig auf preiswerten Substraten wie Glas, Metall- oder Plastikfolien aufgebracht werden, sind noch nicht so etabliert, haben aber aufgrund des geringeren Materialverbrauchs und einer großflächigen Fertigung ein hohes Kostenreduktionspotential.

In der Dünnschichttechnologie ist die Zellen- und Modulentwicklung aus hydrogenisiertem amorphem Silizium (α-Si:H) am weitesten fortgeschritten. Die Basis dieser α-Si:H-Zellenkonzepte bildet dabei in der Regel die sogenannte p-i-n-Superstratkonfiguration mit der Schichtenfolge Substrat (Glas)/transparente Elektrode (Fluordotiertes Zinnoxid)/p-dotiertes Siliziumcarbid/undotiertes α-Si:H/n-dotiertes α-Si:H/Metall. Bei dieser Konfiguration dringt das Sonnenlicht von der Substratseite in die meist 0,5 *µ*m dicke aktive undotierte Absorberschicht ein.

Silizium-Dünnschichtsolarzellen benötigen eine transparente und leitfähige Oxidschicht (TCO-Schicht = transparent conductive oxide) mit einer rauen Oberfläche, die an der Grenzfläche zum silizium das einfallende Licht derart in die Solarzelle streut, dass dieses dort die Solarzelle mehrfach durchläuft. Im optimalen Fall wird das Licht so vollständig absorbiert. Als eine dafür geeignete Schicht wurde im Labormaßstab eine mit Aluminium dotierte Zinkoxid (ZnO:Al) Schicht eingesetzt, die kostengünstig in großen Mengen hergestellt werden sollte. Neben der hohen Durchlässigkeit für sichtbares Licht müssen diese TCO Schichten einen geringen Widerstand aufweisen.

Zur Herstellung einer rauen TCO-Schicht sind prinzipiell zwei verschiedene Verfahren aus der Literatur bekannt. Im ersten Fall kann eine solche TCO-Schicht durch gezieltes Wachsen einer rauen Schicht durch geeignete Steuerung während der Herstellung erhalten werden. Mit dieser Methode werden derzeit großflächig raue Zinnoxidschichten mit Hilfe der CVD (chemical vapor deposition) Technik hergestellt.

Bei der zweiten Methode wird zunächst eine glatte TCO-Schicht erzeugt, die anschließend in einem Ätzprozess nachträglich entsprechend aufgeraut wird. Der letztgenannte Prozess wird derzeit intensiv erforscht und auf seine Übertragbarkeit auf die industrielle Herstellung großer Flächen überprüft. Bei diesem Verfahren wird Zinkoxid, insbesondere mit Al dotiertes Zinkoxid (ZnO:Al) eingesetzt. Mit Hilfe der Kathodenzerstäubung (Sputtern) werden entsprechende Schichten erzeugt. Diese weisen gegenüber den rau gewachsenen Schichten deutlich verbesserte elektrische und optische Eigenschaften auf. Diese Eigenschaften werden signifikant durch die Verfahrensparameter, insbesondere Druck und Temperatur während des Sputterprozesses beeinflusst. Nach dem Sputtern weisen diese Schichten jedoch regelmäßig noch nicht die erforderliche Rauhigkeit auf. Das bedeutet, sie sind optisch glatt und zeigen keinerlei Lichtstreuung. In einem nachfolgenden Prozessschritt werden diese Schichten daher zur Aufrauung regelmäßig nasschemisch geätzt.
Hochleitfähige und transparente ZnO-Schichten können sowohl über reaktive Sputtertechniken von metallischen Zn als auch über nichtreaktive bzw. teilreaktive Sputtertechniken von keramischen Targets hergestellt werden.

Sehr gute Erfolge wurden bislang mit RF-Sputtern von keramischen Targets erzielt. Dabei wird durch Beschuss mit Ar-Ionen ein Target des jeweiligen Schichtmaterials abgetragen und auf einem gegenüber angeordneten Substrat abgeschieden. Die Kombination mit anderen Methoden, beispielsweise dem Verdampfen einzelner Elemente (Hybridsputtern) oder Beimischung eines Reaktionsgases (N₂, O₂, oder auch Ozon) zum Plasma (Reaktivsputtern) ist dabei möglich.

In [1] wird der Stand der Technik zur großflächigen Herstellung von ZnO-Schichten mit Hilfe des reaktiven Magnetronsputterns beschrieben. Dort wird die Substrattemperatur bei maximal 200 °C gehalten. Die Optimierung des Arbeitspunkts erfolgt durch die Steuerung der Generator-Leistung, wodurch ein spezifischer Sauerstoffpartialdruck stabilisiert werden kann. Bei der Optimierung der Schicht für den nachfolgenden Ätzprozess wurde als zentraler Parameter der Sputterdruck während der Herstellung und in engen Bereichen die Temperatur, jedoch nicht über 200 °C, variiert.

Die in [1] beschriebenen, reaktiv gesputterten ZnO-Schichten wurden mit einem industriellen Sputterprozess entwickelt und sind ebenfalls ätzbar. Die derart hergestellten Schichten sind gut leitfähig und transparent, weisen jedoch nachteilig keine optimalen lichtstreuenden Eigenschaften auf. Der Wirkungsgrad von Solarzellen, die diese Schichten aufweisen, ist regelmäßig deutlich geringer als von solchen Solarzellen, bei denen die durch RF-Sputtern von keramischen Targets hergestellten TCO-Schichten eingesetzt werden.

### Aufgabe und Lösung

Die Aufgabe der Erfindung ist es, transparente und leitfähige Oxidschichten (TCO-Schichten) mit verbesserten optischen und elektrischen Schichteigenschaften zur Verfügung zu stellen, die für den Einsatz in Dünnschichtsolarzellen eine geeignete Oberflächenstruktur aufweisen. Eine weitere Aufgabe der Erfindung ist es, ein entsprechendes schnelles und großtechnisch einsetzbares Herstellungsverfahren zur großflächigen Herstellung der vorgenannten Schichten bereit zu stellen.

Die Aufgabe wird gelöst durch ein Verfahren zur Erzeugung einer TCO-Schicht mit der Gesamtheit an Merkmalen gemäß Hauptanspruch. Vorteilhafte Ausführungsformen des Verfahrens finden sich in den entsprechenden rückbezogenen Ansprüchen.

### Gegenstand der Erfindung

Bei reaktiven Sputterprozessen wird der Arbeitspunkt in der Regel derart eingestellt, dass sich durch den Herstellungsprozess Schichten mit optimalen elektrischen und optischen Eigenschaften ergeben. Die dieser Erfindung zugrunde liegende Idee basiert darauf, dass die Auslegung des Arbeitspunktes für den Sputterprozess nicht ausschließlich nach der zu erzeugenden Schicht direkt im Anschluss an den Herstellungsprozess ausgerichtet wird, sondern den sich für die Solarzellenanwendung üblicherweise anschließenden Ätzprozess mit einbezieht.

Bei dem Vorliegenden Verfahren handelt es sich um ein reaktivves Sputterverfahren, bei dem ein metallisches Zn-Target eingesetzt wird. Es werden Leistungsdichten von 5,3 W/cm² bzw. 13 W/cm² eingestellt, mit denen stationäre Depositionsraten von mehr als 150 nm/min, bzw. von mehr als 400 nm/min erreicht werden. Dies entspricht ungefähr dynamischen Depositionsraten von mehr als 40 nm*m/min, bzw. von mehr als 110 nm*m/min bei der Verwendung von zwei Magnetron-Kathoden.

Das Zn-Target weist einen Anteil von Dotieratomen auf. Geeignete Dotierstoffe sind neben Aluminium auch B, Ga, In, oder F. Der Dotiergehalt im Target beträgt regelmäßig weniger als 2,3 at-%, insbesondere weniger als 1,5 at-% und vorteilhaft zwischen 0,2 und 1 at-%. Der Dotiergehalt bezieht sich bei diesen Angaben jeweils nur auf die metallische Komponente, das bedeutet, dass der Sauerstoff nicht mit eingerechnet wird. Dementsprechend berechnet sich der Gehalt an Aluminium nach: Al/(Al+Zn).

Das Target wird üblicherweise schon als dotiertes Target in dem Prozess eingesetzt. Alternativ kann eine Dotierung des Targets aber auch reaktiv erst während des Prozesses über die Gasphase erfolgen. Dies kann insbesondere durch Zugabe von Diboran B₂O₆ zu den Sputtergasen Argon und Sauerstoff realisiert werden.

Ein niedriger Dotiergehalt bewirkt in der herzustellenden Schicht vorteilhaft eine Verbesserung der Transmission. Transmissionswerte beziehen sich in der Regel auf eine Mittelung über den Spektralbereich von 400 bis 1100 nm, also im roten und infraroten Spektralbereich. Gleichzeitig wird durch einen geringen Dotiergehalt die Konzentration der Dotieratome verringert, wodurch die Streuung an ionisierten Störstellen ebenfalls reduziert und die Beweglichkeit der Ladungsträger regelmäßig erhöht wird. Aluminium hat sich als Dotierstoff als besonders effektiv herausgestellt.

Das Substrat wird auf Temperaturen oberhalb von 200 °C aufgeheizt. Vorteilhaft sind Temperaturen oberhalb von 250 °C, insbesondere oberhalb von 300 °C. Obwohl in der Literatur [2] mit steigender Substrattemperatur ein erhöhtes Risiko einer Zn-Kontaminationen vorhergesagt wird, und daher Substrattemperaturen von maximal 150 °C empfohlen werden, führen die hohen Temperaturen auch bei mehrmonatigem Betrieb des erfindungsgemäßen Verfahrens regelmäßig zu keiner Beeinträchtigung durch eine Kontamination.

Das Herstellungsverfahren erfordert in der Regel eine Kontrolle des Reaktivgasflusses, bzw. des Reaktivgaspartialdrucks im Depositionsraum. Als Reaktivgas wird Sauerstoff und als Sputtergase werden Argon und Sauerstoff eingesetzt. Alternativ kann auch Ozon verwendet werden. In der Regel wird für das nicht reaktive Sputtern Ar und zum Sputtern von Oxidschichten Sauerstoff und Argon verwendet. Zur Stabilisierung verschiedener Arbeitspunkte des Reaktivprozesses im Transision-Mode wird ein Plasma-Emissions-Monitor (PEM) verwendet. Die Intensität der Emissionslinie atomaren Zinks wird ausgewertet, um den Sauerstoffzufluss in das Reaktionsvolumen zu steuern. Ein Arbeitspunkt ist durch eine feste Intensität der Zinkemission charakterisiert. Eine weitere Möglichkeit der Stabilisierung besteht beispielsweise in der Kontrolle des Sauerstoff-Partialdrucks, der beispielsweise mittels einer Lambda-Sonde gemessen werden kann.

Jeder Arbeitspunkt kann zu einer unterschiedlichen Materialeigenschaft der ZnO:Al-Schicht, insbesondere zu einer unterschiedlichen Oberflächenrauhigkeit nach dem sich anschließenden Ätzschritt führen. Daher werden im Vorfeld unter sonst gleichen Prozessbedingungen zunächst ZnO-Schichten bei verschiedenen Arbeitspunkten hergestellt. Das bedeutet, dass unter sonst gleichen Bedingungen wie Depositionsdruck, Substrattemperatur, Leistung und Schichtdicke verschiedene stabilisierte Arbeitspunkte entlang der Hysterese, bzw. im instabilen Hysteresebereich eingestellt und so entsprechende Schichten hergestellt werden.

Zur Stabilisierung verschiedener Arbeitspunkte des Reaktivprozesses im Transision-Mode kann ein Plasma-Emissions-Monitor (PEM) verwendet werden. Die Intensität der Emissionslinie atomaren Zinks wird ausgewertet, um den Sauerstoffzufluss in das Reaktionsvolumen zu steuern. Ein Arbeitspunkt ist durch eine feste Intensität der Zinkemission charakterisiert.

Bei vorgegebenen Prozessparametern, wie Leistung, Depositionsdruck und Temperatur, zeigen die möglichen, stabilisierten Arbeitspunkte innerhalb des instabilen Prozessbereichs einen S-förmigen Verlauf. Der erfindungsgemäße Arbeitspunkt wird nun nach folgenden Kriterien ausgewählt.
- er liegt im instabilen Bereich der Hysterese, und bedarf der Prozesskontrolle und
- er liegt gleichzeitig im oberen, das heißt im metallischen Bereich des Hysteresebereichs.

Die auf diese Weise hergestellten Schichten müssen jedoch alle gewisse Mindestanforderungen an Transparenz und Leitfähigkeit erfüllen. Der spezifische Widerstand sollte dabei kleiner als 1*10⁻³ Ω cm sein, und die Transmission größer als 80 % sein. Je oxidischer die Bedingungen sind, desto höher ist in der Regel der spezifische Widerstand der Schicht.

Die mit dem erfindungsgemäßen Verfahren hergestellten ZnO-Schichten weisen vor einer Nachbehandlung insbesondere die folgenden Eigenschaften auf:
◆ Der Gehalt an Dotierstoff, insbesondere an Aluminium, in der hergestellten Schicht beträgt weniger als 3,5 at-%, vorteilhaft sogar weniger als 3 at-%, insbesondere weniger als 2,5 at-% und mehr als 1,5 at-%.
◆ Der spezifische Widerstand ist kleiner als 1*10⁻³ Ω cm, insbesondere kleiner als 5*10⁻⁴ Ω cm.
◆ Die Ladungsträgerbeweglichkeit ist größer als 25 cm²/V s, insbesondere größer als 35 cm²/V s.
◆ Die Transmission ist größer als 80 %, vorteilhaft größer 82 %. Die Transmissionswerte gelten jeweils für das System Glassubstrat mit Schicht und werden über den für Silizium-Solarmodule nutzbaren Bereich zwischen 400 nm und 1100 nm gemittelt.

Nach der Herstellung der ZnO-Schicht erfolgt die Nachbehandlung in Form von nasschemischem Ätzen oder Trockenätzen. Durch diesen Ätzschritt wird die Oberfläche der ZnO-Schicht texturiert und erhält die Oberflächenrauhigkeit, die beim Einsatz in Siliziumdünnschichtsolarzellen regelmäßig erst die hohen Stromdichten ermöglichen. Bei dem erfindungsgemäßen Verfahren entwickelt sich eine gleichmäßige Oberflächenrauhigkeit der ZnO-Schicht, beispielsweise mit einer RMS-Rauhigkeit von wenigstens 30 nm und höchstens 300 nm aus. Mit der Ätzdauer nimmt die Rauhigkeit in der Regel bis zu einem gewissen Punkt zu. Eine untere Grenze der Rauhigkeit kann durch Variation der Ätzzeiten von nahezu beliebig klein bis zu einer Obergrenze eingestellt werden. Als untere Grenze kann wenigstens mehr als 1 nm angenommen werden, da eine gewisse Rauhigkeit nach dem Sputtern schon vorhanden ist. Die obere Grenze ist von der sich entwickelnden Oberflächenstruktur abhängig.

Die RMS-Rauhigkeit des Verfahrens (δ_{RMS}) nach dem Ätzprozess liegt in der Regel zwischen 30 nm und 300 nm. Unter der RMS-Rauhigkeit (rout mean square roughness) ist die mittlere Rauhigkeit zu verstehen. Für α:Si hat sich eine mittlere Rauhigkeit von 50 bis 100 nm, für mikrokristalline Siliziumsolarzellen von 50 bis 300 nm als günstig herausgestellt. Für Stapelsolarzellen, die beide Solarzellentypen enthalten, sind mittlere Rauhigkeiten zwischen 50 und 200 nm vorteilhaft.

Erst nach diesem Nachbehandlungsschritt wird die Qualität der ZnO-Schicht und die Eignung als Frontkontakt für Solarzellen am zuverlässigsten durch den Einsatz in einer Solarzelle überprüft. Dabei werden dann insbesondere die photovoltaischen Kenngrößen ermittelt. Diese Vorgehensweise ist deshalb notwendig, weil es bislang keine zuverlässigen theoretischen Arbeiten gibt, die die für den Einsatz in einer Solarzelle benötigten Eigenschaften der Schicht zuverlässig beschreiben.

Die Ätzbedingungen für die sich an die Herstellung der ZnO:Al-Schichten erfolgte Ätzung können unabhängig von den Schichteigenschaften variiert werden. Sie gehören also nicht zu den Schichtherstellungsparametern, die der Erfindung zugrunde liegen. Im wesentlichen ist die Oberflächenstruktur nach dem Ätzen durch die Schichteigenschaften selbst bestimmt. Eine Feinoptimierung erfolgt durch Variation der Ätzdauer. Auch die Wahl des Ätzmediums, beispielsweise Säure oder Lauge, kann einen Einfluss auf das Endergebnis haben. In der Regel wird verdünnte Salzsäure (HCl) zum Aufrauen der Schichten verwendet.

Bislang wird der Arbeitspunkt für den Sputterprozess derart eingestellt, dass die optischen und elektrischen Eigenschaften der ZnOSchicht optimal sind. Demgegenüber wird der Arbeitspunkt bei dem erfindungsgemäßen Verfahren als entscheidender Parameter zur Kontrolle des Ätzverhaltens der Schichten verwendet. Dabei werden die Mindestanforderungen an die elektrischen und optischen Eigenschaften berücksichtigt.

Eine vorteilhafte Ausgestaltung des erfindungsgemäßen Verfahrens sieht vor, eine Doppelmagnetronanordnung mit mf (medium frequency) Anregung zu verwenden. Weiterhin hat es sich als vorteilhaft herausgestellt, das Verfahren als einen dynamischen Durchlaufprozess durchzuführen, bei dem das Substrat während des Sputterns unter dem Carrier hin und her bewegt wird.

### Spezieller Beschreibungsteil

Nachfolgend wird der Gegenstand der Erfindung anhand von Figuren und Ausführungsbeispielen näher erläutert, ohne dass der Gegenstand der Erfindung dadurch beschränkt wird. Es zeigen
- Figur 1:: Transmission von ZnO:Al-Schichten.
- Figur 2:: Entladungsspannung (U) und Plasma-Emissions (PEM)-Intensität als Funktion des Sauerstoffflusses (schematisch).
- Figur 3:: Generatorspannung und Plasma-Emissions (PEM)-Intensität als Funktion des Sauerstoffflusses mit Kennzeichnung erfindungsgemäßer Arbeitspunkt.
- Figur 4:: SEM-Oberflächenaufnahmen verschiedener ZnO-Schichten nach dem Ätzen in verdünnter Salzsäure:
a) Schicht, hergestellt durch erfindungsgemäßen Arbeitspunkt;
b) Schicht, hergestellt durch nicht optimalen Arbeitspunkt im metallischen Bereich.

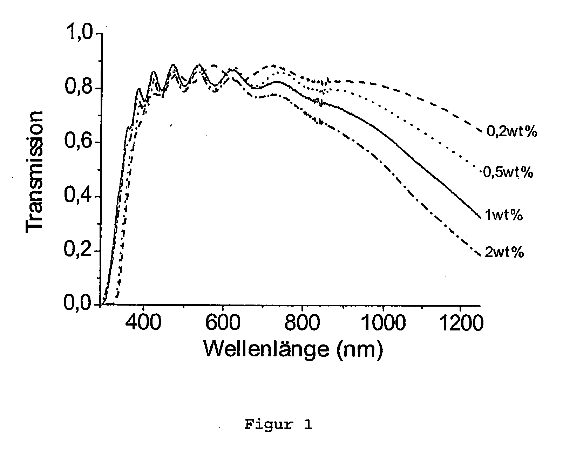

Die Figur 1 zeigt die Transmission von ZnO:Al-Schichten, die von Targets mit unterschiedlichem Aluminiumgehalt gesputtert wurden. Im roten und infraroten Teil des Spektrums nimmt die Transmission mit steigendem Aluminiumgehalt ab. Für die Anwendung in mikrokristallinen Siliziumsolarmodulen ist eine hohe Transparenz bis zu ca. 1100 nm nötig, so dass ein niedriger Aluminiumgehalt vorteilhaft ist.

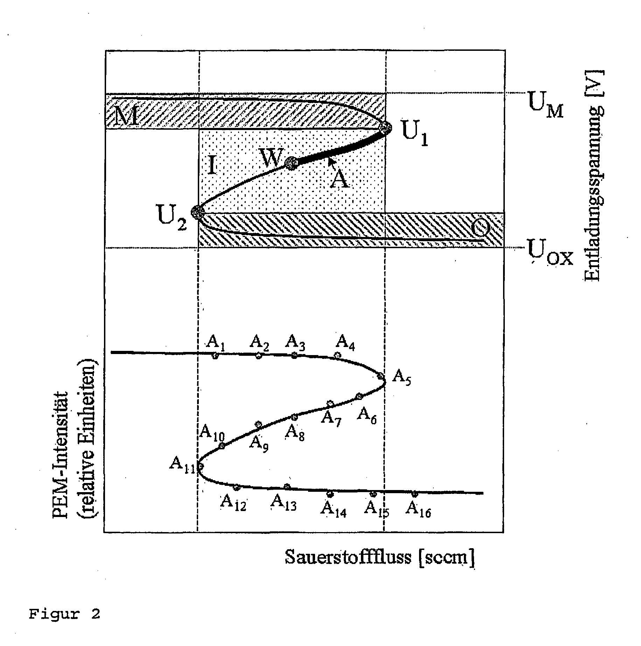

Figur 2 zeigt schematisch den Hysteresebereich (zwischen den gestrichelten Linien) des reaktiven Sputterprozesses. Bei kleinen Sauerstoffflüssen und hohen Entladungsspannungen findet sich das stabile Prozessfenster M im metallischen Bereich, bei großen Sauerstoffflüssen und geringen Entladungsspannungen findet sich das stabile Prozessfenster im oxidischen Bereich O. U_{M} kennzeichnet die Entladungsspannung bei Sputterprozessen im voll-metallischen Bereich, Uₒₓ die Entladungsspannung bei voll-oxidischen Prozessen. Ferner bedeuten in dem oberen Teil der Figur 2:
- Bereich I:: instabiler Prozessbereich, in dem eine Prozesskontrolle notwendig ist,
- Bereich A:: Prozessfenster für die erfindungsgemäß ausgewählten Arbeitspunkte mit gewünschten Eigenschaften,
- Bereich O:: stabiles Prozessfenster im oxidischen Bereich und
- Bereich M:: stabiles Prozessfenster im metallischen Bereich.
- Punkt U1**:**: Umkehrpunkt vom stabilen, metallischen Prozess zum instabilen Prozess
- Punkt U2:: Umkehrpunkt vom stabilen, oxidischen Prozess zum instabilen Prozess
- Punkt W:: Wendepunkt der stabilisierten Prozesskurve.

Im unteren Teil der Figur sind einzelne Arbeitspunkte A₁ bis A₁₆ auf einer Prozesskurve der Intensität der Plasmaemission (PEM) von atomarem Zink gegen den Sauerstofffluss eingetragen. Die Arbeitspunkte wurden durch eine konstante PEM-Intensität mit dem Sauerstofffluss als Regelgröße festgelegt. Dabei kennzeichnen die Punkte A₅ - A₇ solche Arbeitspunkte im instabilen Bereich, die im Rahmen dieser Erfindung als besonders geeignet ausgewählt werden, während die Arbeitspunkte A₂ bis A₄ optimale elektrische Eigenschaften bei den hergestellten Schichten bewirken.

Unterschiedliche Arbeitspunkte wirken sich auf die Transmission der Schichten ähnlich aus, wie unterschiedlicher Aluminiumgehalt. Je oxidischer der Arbeitspunkt (niedrige PEM-Intensität) gewählt wird, desto höher fällt die Transmission im roten und infraroten Bereich aus.

Der im Rahmen dieser Erfindung ausgewählte Bereich für geeignete Arbeitpunkte lässt sich im oberen Teil der Figur 2 als der Bereich auf der Prozesskurve zwischen U₁ und W kennzeichnen. Das bedeutet, man sollte Prozess-kontrollierte Arbeitspunkte einstellen, die im instabilen, metallischen Bereich liegen.

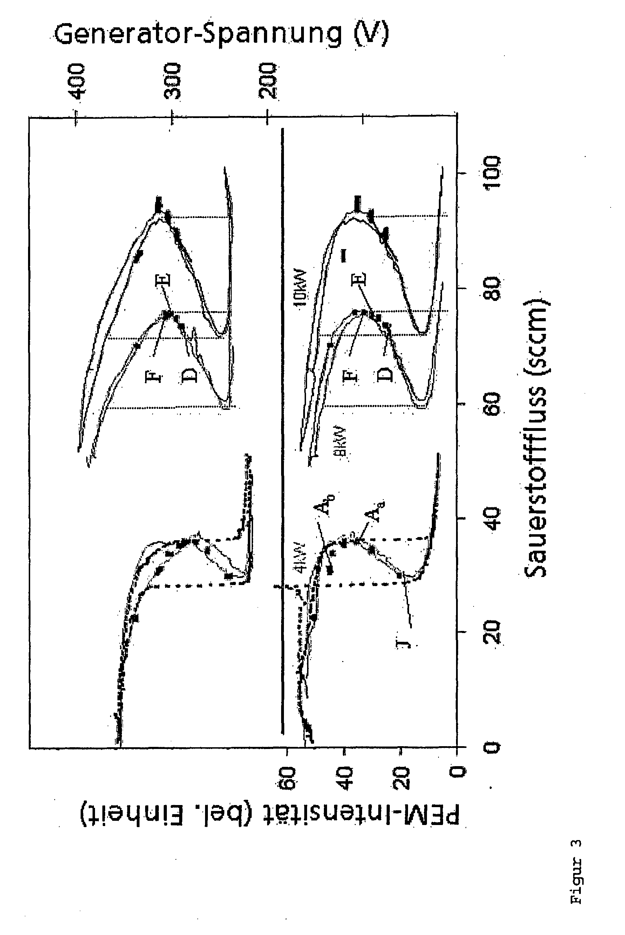

Figur 3 verdeutlicht dieses Prinzip. Hier sind drei Serien mit jeweils unterschiedlichen Prozessparametern wie Depositionsdruck, Leistung und Temperatur gegen den Sauerstofffluss aufgetragen. Der obere Teil zeigt die Auftragungen gegen die Generatorspannung, die proportional zu der Entladungsspannung ist. Die drei dargestellten Kurven zeigen einen bezüglich der X-Achse verschobenen Kurvenverlauf, der durch die unterschiedlichen Leistungen von 4, 8 und 10 kW herrührt. Bei jeder Serie ist der instabile Prozessbereich durch gestrichelte Linien kenntlich gemacht. Bei der mittleren Kurve sind zusätzlich drei ausgewählte Arbeitspunkte D, E und F eingetragen.

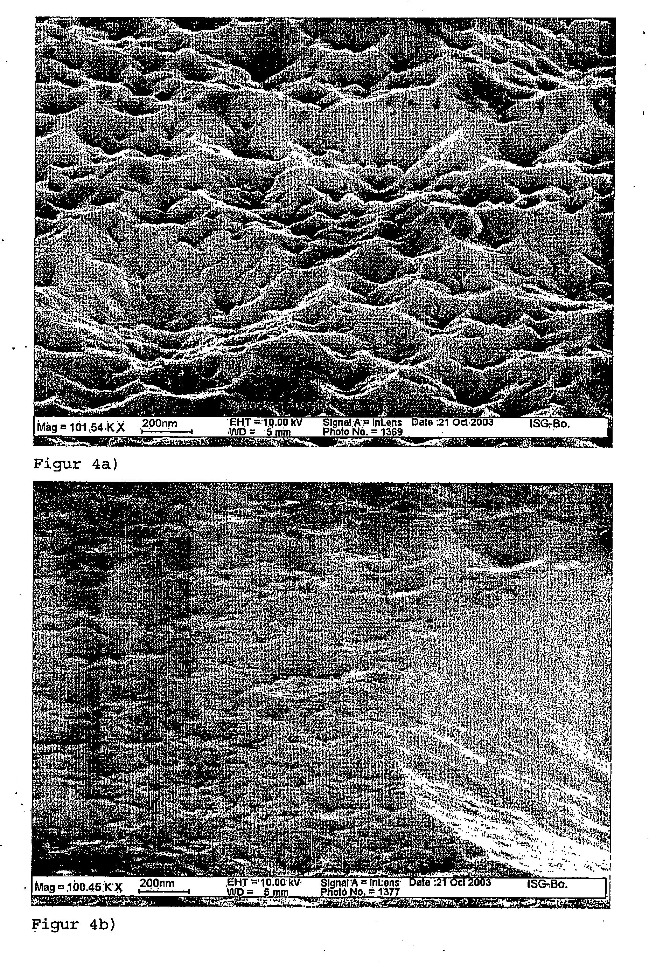

Bei der im unteren Teil der Figur 4 gezeigten Darstellung der drei Serien gegen die PEM-Intensität sind zudem zwei weitere Arbeitspunkte Aₐ und A_{b} eingetragen.

Figur 4 zeigt die elektronenmikroskopische (SEM) Oberflächenaufnahmen von ZnO:Al-Schichten, die bei den oben erwähnten Arbeitspunkten Aₐ und A_{b} hergestellt wurden. Nach der Herstellung wurden die Schichten in verdünnter Salzsäure (HCl) geätzt. Die Figur 4a) zeigt eine Schichtaufnahme bei dem Arbeitspunkt Aₐ, der aus dem erfindungsgemäßen Bereich ausgewählt wurde. Die mittlere Rauhigkeit beträgt ca. 70 nm.
Demgegenüber weist die Schicht beim Arbeitspunkt A_{b} eine deutlich geringere Rauhigkeit auf, was sich beim Einsatz in einer Solarzelle in einem deutlich geringeren Wirkungsgrad niederschlägt.

Die Erfindung schafft ein Verfahren für die Herstellung von leitfähigen und transparenten Zinkoxidschichten auf einem Substrat, mittels eines reaktiven Sputterprozesses, bei dem bewusst der.Arbeitspunkt für optimale elektrische Eigenschaften innerhalb einer Serie verlassen wird und demgegenüber ein Arbeitspunkt indem metallischen, instabilen Bereich der Prozesskurve ausgewählt wird.

Die nachfolgende Tabelle zeigt die Kenngrößen von im Rahmen der Erfindung hergestellten Solarzellen auf, die auf verschiedenen ZnO-Substraten hergesellt wurden. Als Kengrößen werden die Plasmaintensität PEM, die Depositionsrate, der spezifische Widerstand p in der Schicht vor dem Ätzen, der Wirkungsgrad η, der Füllfaktor FF, die Leerlaufspannung V_{oc} und die Kurzschlussstromdichte J_{sc} eingetragen.

| Bereich | Schicht | PEM a.u. | Depositions-rate nm*m/min | Rho 10⁻⁴ Ohm cm | R_{square} Ohm | Eta % | FF % | Voc mV | Jsc mA/cm² |
|---|---|---|---|---|---|---|---|---|---|
| A | A | 35 | 95 | 3,4 | 3,9 | 8,2 | 70,8 | 516 | 22,4 |
| A | B | 30 | 92 | 5,6 | 6,6 | 8,0 | 71,8 | 497 | 22,7 |
| A | C | 40 | 41 | 4,5 | 10 | 8,1 | 71,0 | 523 | 21,9 |
| A | D | 25 | 96 | 9,1 | 16,6 | 7,9 | 69,6 | 504 | 22,5 |
| A | E | 27,5 | 92 | 5,6 | 11,9 | 7,8 | 67,4 | 507 | 22,7 |
| A | F | 30 | 91 | 4,0 | 6,6 | 8,0 | 71,7 | 497 | 22,5 |
| M | G | 50 | 42 | 2,8 | 4,5 | 6,4 | 73,0 | 504 | 17,5 |
| M | H | 46 | 42 | 3,4 | 5,0 | 7,2 | 72,9 | 515 | 19,1 |
| M | I | 42 | 43 | 3,2 | 4,8 | 6,9 | 71,1 | 492 | 19,8 |
| O | J | 20 | 41 | 40000 | | | | | |
| K | K | 46 | 44 | 8,1 | 7,0 | 5,9 | 62,3 | 488 | 19,5 |
| K | L | 50 | 42 | 3,9 | 4,7 | 6,3 | 66,8 | 492 | 19,3 |
| K | M | 54 | 33 | 3,3 | 4,9 | 6,4 | 71,1 | 521 | 17,4 |
| Referenz | N | - | 6 | 2,5 | 3,0 | 8,3 | 71,1 | 505 | 23,0 |

Die Schichten sind an unterschiedlichen Bereichen der in Figur 2 dargestellten Hysterese und deren Stabilisierung hergestellt. Die verschiedenen Schichten werden im Folgenden erläutert.

Die rau geätzten Schichten wurden als Substrate in Solarzellen eingesetzt. Die Kenngrößen einiger Schichten und der Solarzellen auf diesen Substratschichten sind in der Tabelle aufgelistet. Bereich A kennzeichnet die erfindungsgemäß hergestellten Schichten. Die Schichten D-F zeigen eine Feinoptimierung der Herstellungsparameter in diesem Bereich. Die Schichten G-I wurden im metallischen Bereich des Reaktivprozesses am oberen Ast der Hysteresekurve hergestellt, der dem derzeitigen Stand der Technik entspricht und die elektrisch besten Schichten liefert.

Das veränderte Ätzverhalten und die daraus resultierende Oberflächenrauhigkeit können die Stromausbeute in den Solarzellen deutlich erhöhen (vgl. Bereich A und M). Verluste durch den erhöhten Widerstand begrenzen hingegen bei oxidisch gesputterten Schichten den Wirkungsgrad der Solarzellen. Den Extremfall repräsentiert Schicht J (Bereich O), die aufgrund des hohen Widerstandes als Kontaktschicht nicht geeignet ist. Die veränderte Stromausbeute durch den Arbeitspunkt ist unabhängig von den sonstigen Herstellungsparametern, wie Substrattemperatur und Depositionsdruck, zu beobachten. Die Leerlaufspannung der Solarzellen wird leicht durch das verwendete Substrat beeinflusst. Dieser Effekt ist jedoch vergleichsweise gering. Die Schichten K-M mit der Kennung K, wurden bei Substrat-Temperaturen Tₛ < 220 °C hergestellt und zeigen deutlich, dass eine hohe Substrattemperatur notwendig ist, um gute ZnO:Al-Substratschichten für Silizium-Solarzellen herzustellen. Alle Solarzellen-Kenngrößen auf einem zu kalt gesputterten Substrat zeigen Defizite, die sich in einem schlechten Wirkungsgrad widerspiegeln. Als Vergleichsschicht ist eine nicht reaktiv rfgesputterte Schicht N angegeben. Die Schicht N zeigt in den Solarzellen die besten Eigenschaften, ist jedoch aufgrund der geringen Depositionsrate (Faktor 10) nicht für die industrielle Fertigung von Solarmodulen kosteneffektiv nutzbar. Letztere und die Schichten aus dem erfindungsgemäßen Bereich A zeigen in den Solarzellen gute Wirkungsgrade von 8 % und mehr.

In dieser Anmeldung zitierter Stand der Technik:
[1] J. Müller et al, State-of-the-art mid-frequency sputtered ZnO films for thin film silicon solar cells and modules, Thin Solid Films 442 (2003) 158-162.
[2] B. Szyszka et al., Transparent and conductive ZnO:Al films deposited by large area reactive magnetron sputtering, Thin Solid Films 442 (2003) 179-183.

## Patentansprüche

1. Verfahren zur Herstellung einer leitfähigen und transparenten Zinkoxidschicht auf einem Substrat durch reaktives Sputtern, wobei der Prozess einen Hysteresebereich aufweist, und
- der Heizer für das Substrat so eingestellt wird, dass eine Substrattemperatur oberhalb von 200 °C eingestellt wird, und
- eine dynamische Depositionsrate von mehr als 50 nm*m/min ein-gestellt wird, welches einer statischen Depositionsrate von mehr als 190 nm/min entspricht,
**gekennzeichnet durch** die Schritte:
- es wird ein metallisches Zn Target mit einer Dotierung verwendet, wobei der Dotiergehalt des Targets weniger als 2,3 at-% beträgt,
- zur Kontrolle des Ätzverhaltens und einer daraus resultierenden Oberflächenrauigkeit der ZnO-Schicht wird ein stabilisierter Arbeitspunkt innerhalb des instabilen Prozessbereichs gewählt, der zwischen dem Umkehrpunkt zwischen stabilem, metallischen und instabilem Prozess und dem Wendepunkt der stabilisierten Prozesskurve liegt,
- es erfolgt eine Nachbehandlung der ZnO-Schicht in Form von nasschemischen Ätzen oder Trockenätzung zur Entwicklung einer RMS- Rauigkeit von 30 bis 300 Nanometer.

2. Verfahren nach vorherigem Anspruch 1, bei dem ein Target mit einem Dotierstoffgehalt von weniger als 1,5 at-%, insbesondere weniger als 1 at-% eingesetzt wird.

3. Verfahren nach einem der Ansprüche 1 bis 2, bei dem ein Target mit Aluminium als Dotierstoff eingesetzt wird.

4. Verfahren nach einem der Ansprüche 1 bis 3, bei dem das Substrat auf Temperaturen oberhalb von 250 °C, insbesondere auf Temperaturen oberhalb von 300 °C aufgeheizt wird.

5. Verfahren nach einem der Ansprüche 1 bis 4, bei dem eine dynamische Depositionsrate von mehr als 80 nm*m/min, insbesondere von mehr als 100 nm/min eingestellt wird, welches einer statischen Depositionsrate von mehr als 300, insbesondere mehr als 380 nm/min entspricht.

6. Verfahren nach einem der Ansprüche 1 bis 5, bei dem eine Doppelmagnetronanordnung mit mf (medium frequency) Anregung verwendet wird.

7. Verfahren nach einem der Ansprüche 1 bis 6, welches als dynamischer Durchlaufprozess durchgeführt wird, bei dem das Substrat während des Sputterns bewegt wird.

## Claims

1. Method for making a conductive and transparent zinc oxide layer on a substrate through reactive sputtering, in which the process has a hysteresis area, and
- the heater for the substrate is set so that a substrate temperature of over 200° C is set and
- a dynamic deposition rate of more than 50 nm*m/min is set, which corresponds ot a static deposition rate of more than 190 nm/min, **characterised by** the steps:
- a metal Zn target with a dopant is used, in which the dopant content of the target amounts to less than 23 at%,
- in order to control the etching behaviour and surface roughness of the ZnO layer resulting from this, a stabilised working point within the unstable process area is selected, which lies between the reversal point between the stable, metal and unstable process and the turning point of the stabilised process curve,
- there is subsequent treatment of the ZnO layer in the form of wet chemical etching or dry etchig to produce an RMS roughness of 30 to 300 nanometres.

2. Method according to previous claim 1, in which a target is used with a dopant content of less than 15 at%, particularly less than 1 at%.

3. Method according to one of claims 1 to 2, in which a target is used with aluminium as the dopant.

4. Method according to one of claims 1 to 3, in which the substrate is heated to temperatures above 250° C, particularly to temperatures above 300° C.

5. Method according to one of claims 1 to 4, in which a dynamic deposition rate of more than 80 nm*m/min, particularly more than 100 nm/min is set, which corresponds to a static deposition rate of more than 300, particularly more than 380 mn/min.

6. Method according to one of claims 1 to 5, in which a double magnetron arrangement with mf (medium frequence) energisation is used.

7. Method according to one of claims 1 to 6, which is carried out as a dynamic continuous process, in which the substrate is moved during sputtering.

## Revendications

1. Procédé de production d'une couche d'oxyde de zinc conductrice et transparente sur un substrat par pulvérisation réactive, le procédé présentant une zone d'hystérèse, et
- le chauffage pour le substrat est ajusté de telle sorte qu'une température de substrat supérieure à 200° C soit ajustée, et
- un taux de dépôt dynamique supérieur à 50 nm*m/min est ajusté, qui correspond à un taux de dépôt statique de plus de 190 nm/min,
**caractérisé par** les étapes suivantes :
- on utilise une cible de Zn métallique comportant un dopage, la teneur en dopage de la cible étant inférieure à 2,3 % at,
- pour le contrôle du comportement de corrosion et d'une rugosité de surface de la couche de ZnO en résultant, un point de travail stabilisé est choisi dans la plage de processus instable, qui se situe entre le point de retour entre le processus stable, métallique et instable et le point d'inflexion de la courbe du processus stabilisée,
- il s'effectue un post-traitement de la couche de ZnO sous la forme de corrosion chimique humide ou de corrosion sèche pour le développement d'une rugosité RMS de 30 à 300 nanomètres.

2. Procédé selon la revendication 1 précédente, dans lequel une cible présentant une teneur en substance de dopage inférieure à 1,5 % at, en particulier, inférieure à 1 % at est choisie.

3. Procédé selon l'une des revendications 1 à 2, dans lequel une cible comportant de l'aluminium comme substance dopante est utilisée.

4. Procédé selon l'une des revendications 1 à 3, dans lequel le substrat est chauffé à une température supérieure à 250° C, en particulier, à une température supérieure à 300° C.

5. Procédé selon l'une des revendications 1 à 4, dans lequel un taux de dépôt dynamique supérieur à 80 nm*m/min, en particulier, supérieur à 100 nm/min est ajusté, qui correspond à un taux de dépôt statique supérieur à 300, en particulier, supérieur à 380 nm/min.

6. Procédé selon l'une des revendications 1 à 5, dans lequel on utilise un dispositif à double magnétron avec une excitation à mf (moyenne fréquence).

7. Procédé selon l'une des revendications 1 à 6, qui est réalisé en tant que processus continu dynamique dans lequel le substrat est déplacé pendant la pulvérisation.
